# EUROPÄISCHE PATENTSCHRIFT

(11) **EP 1 604 278 B1**
(45) Veröffentlichungstag und Bekanntmachung des Hinweises auf die Patenterteilung: **08.04.2009**
(21) Anmeldenummer: 04711983.9
(22) Anmeldetag: 18.02.2004
(51) Int. Cl.: G06F 9/44

(54) **VERFAHREN ZUR ABLAUFSTEUERUNG VON SEQUENTIELLEN OBJEKTORIENTIERTEN SYSTEMSIMULATIONEN**
METHOD FOR CONTROLLING SEQUENTIAL OBJECT-ORIENTED SYSTEM-SIMULATIONS
PROCEDE DE COMMANDE DU DEROULEMENT DE SIMULATIONS DE SYSTEME SEQUENTIELLES ORIENTEES OBJET

(30) Priorität: 20.02.2003 DE 10307408
(43) Veröffentlichungstag der Anmeldung: 14.12.2005
(73) Patentinhaber: Actix GmbH, 01067 Dresden (DE)
(72) Erfinder: VOIGT, Jens, 01309 Dresden (DE)
(74) Vertreter: Adler, Peter
(86) Internationale Anmeldenummer: PCT/DE2004/000303
(87) Internationale Veröffentlichungsnummer: WO 2004/075050

(56) Entgegenhaltungen:
- EP-A- 0 854 429
- DE-A1- 10 104 926
- US-A- 5 794 005
- NEETA GANGULY, VIJAY PITCHUMANI: "HSIM1 and HSIM2: Object Oriented Algorithms for VHDL Simulation" PROCEEDINGS OF THE SEVENTH INTERNATIONAL CONFERENCE ON VLSI DESIGN, 1994, 1. Januar 1994 (1994-01-01), Seiten 175-178, XP002342028 Calcutta, India
- BERNARD P. ZEIGLER: "Object Oriented Simulation with Hierarchical, Modular Models: Selected Chapters Updated for DEVS-C++" INTERNET PUBLICATION, [Online] 1995, XP002342029 Gefunden im Internet: URL:http://www.acims.arizona.edu/PUBLICATI ONS/HTML/objsim.html> [gefunden am 2005-08-16]

## Beschreibung

Die Erfindung betrifft ein Verfahren zur Ablaufsteuerung von sequentiellen objektorientierten Systemsimulationen, in dem Objekte mit zumindest einigen gleichen Eigenschaften zu Objektgruppen zusammengefasst werden und die Objektgruppen in Klassen abgebildet werden und jede Klasse durch einen Simulationsprogrammteil realisiert wird, wobei die Abbildung eines Objektes einer Objektgruppe in einer Instanz der Klasse dadurch erfolgt, dass die Instanz durch eine Einstellung mindestens eines Parameters in dem Simulationsprogrammteil realisiert wird, wodurch dieser zu einem parametrisierten Simulationsprogrammteil wird, und in dem die Instanzen zur Simulation der Kommunikation zwischen Objekten Ereignisse erzeugen und verarbeiten, was durch einen Ablauf der parametrisierten Simulationsprogrammteile realisiert wird, wobei der Simulationsablauf durch Aktivierungen von Instanzen gesteuert wird.

Eine Systemsimulation ist die Ausführung eines Rechnerprogramms, welches das zu untersuchende System in einer für den Untersuchungszweck hinreichenden Abstraktheit modelliert. Eine dynamische Simulation repräsentiert ein System so, wie es sich in der Zeit verhält. Eine zeitdiskrete Simulation ist eine dynamische Simulation, in welcher sich die Zustände der an der Simulation teilnehmenden Objekte zu diskreten Zeitpunkten in einer kontinuierlichen Zeitskala ändern. Derartige Simulationen werden, zur Beherrschung der Größe und Komplexität derartiger Programme, nach einem objektorientierten Prinzip realisiert, dass heißt das Programm besteht aus Programmobjekten, welche miteinander kommunizieren.

Zeitdiskrete Systemsimulationen werden beispielsweise in der Telekommunikationsindustrie zum Entwurf, zur Optimierung und zur Validierung von Funkzugangsnetzen eingesetzt, da sie im Gegensatz zu statischen "Monte-Carlo-Simulationen" eine zeitliche Historie des simulierten Modells nachbilden können, welche zur Analyse des Einflusses der Bewegung von Mobilfunkteilnehmern, einer Vielzahl paketvermittelter Dienste oder auch des zunehmenden Einsatzes adaptiver Komponenten in Funkzugangsnetzen, beispielsweise mit einem WCDMA-Mehrfachzugriffsverfahren, notwendig ist. Damit sind zeitdiskrete Systemsimulationen auch besonders geeignet, um Algorithmen eines Funkzugangsnetzes, wie sie bei der Verwaltung der Funkressourcen auftreten, untersuchen zu können. Ein Funkzugangsnetz ist hierbei der funknetzrelevante Teil eines Mobilfunknetzes.

Die Steuerung des Ablaufs der Kommunikationen zwischen Objekten in zeitdiskreten Simulationen ist eine Aufgabe der Simulationsablaufsteuerung, welche ein oder auch mehrere Simulationsverfahren implementiert. Ein Simulationsverfahren ist z.B. nach E.A.Lee and A. Sangiovanni-Vincentelli: A Framework for Comparing Models of Computation, in IEEE Transactions on Computer Aided Design of Integrated Circuits and Systems, vol. 17(12), pp. 1217-1229, Dez. 1998 die Semantik der Kommunikation zwischen Objekten.

In E. A. Lee, "Modeling Concurrent Real-time Processes Using Discrete Events", Invited paper, Annals of Software Engineering, Special Volume on Real-Time Software Engineering, vol. 7 (1999), pp. 25-45, Feb. 19997 wird eine Ablaufsteuerung einer zeitdiskreten Simulation mittels diskreter Ereignisse dargestellt. Die Kommunikation zwischen Objekten wird hier mittels Ereignissen behandelt. Ereignisse tragen neben der eigentlich zwischen den Objekten auszutauschenden Information, dem Informationswert, einen Adresswert, welcher aus der Quell- und der Zieladresse bestehen kann, und einen Zeitstempel, durch den sie beispielsweise in einer zeitlichen Reihenfolge geordnet werden können. Weitere mögliche Ordnungskriterien sind eine topologische Sortierung oder nutzerabhängige Prioritäten der kommunizierenden Objekte.

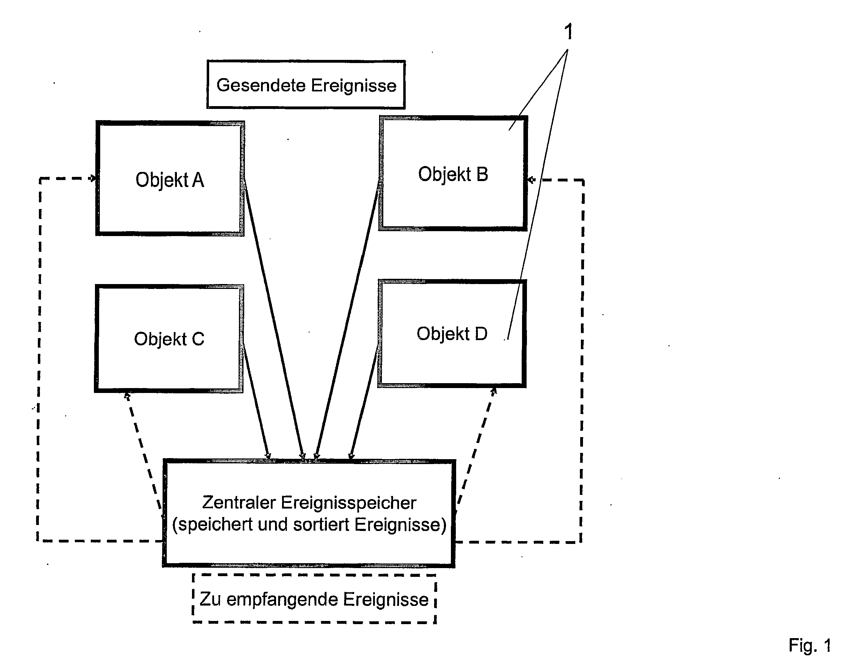

Durch das Suchen des Ereignisses mit dem jeweils kleinsten Zeitstempel im zentralen Ereignisspeicher und das Weiterleiten dieses Ereignisses an dass das Ereignis empfangende Objekt sowie dessen Verarbeitung des Ereignisses und der Rücksendung keines, eines oder mehrerer Ereignisse an den zentralen Ereignisspeicher schreitet die Simulation und damit die Simulationszeit voran, wie dies auch aus Fig. 1 ersichtlich ist. Simulationen mittels diskreter Ereignisse gehören damit zur Gruppe der laufzeitgeplanten Simulationsverfahren. Laufzeitgeplante Simulationsverfahren planen oder generieren den Ablauf der Simulation erst zur Laufzeit des Programms selbst. Im Gegensatz dazu planen kompilierzeitgeplante Simulationsverfahren den Ablauf einer Simulation bereits vor Ausführung des Programms.

In umfangreichen Simulationen treten durch die Kommunikation zwischen den Objekten sehr viele Ereignisse auf. Diese Ereignisse müssen in der oder den Listen des zentralen Ereignisspeichers eingeordnet werden, auch wenn sie zur Kommunikation zwischen völlig unabhängigen Objekten dienen. Sowohl das Einordnen in diese Listen als auch das Suchen des Ereignisses mit dem jeweils kleinsten Zeitstempel kann bei sehr langen Ereignislisten mit sehr vielen Ereignissen sehr zeitaufwändig sein.

Ein neuerer Kenntnisstand der Theorie von zeitdiskreten Systemsimulationen von Funkzugangsnetzen zeigt u.a. in (J. Voigt and G. Fettweis: A Cycle-Based Approach for Parallel Simulations of Mobile Communications Networks, in: Symposium on Performance Evaluation of Computer and Telecommunications Networks (SPECTS'2k), pp. 139-143, Vancouver, BC, Canada, July 2000) und in der DE 101 04 926 A1, dass die Kommunikation der Objekte synchron und außerdem in einem Ereigniszyklus stattfinden kann. Durch die Kenntnis der Synchronität der Empfangszeit der Ereignisse und damit des Ereigniszyklus ist der Ablauf der Simulation bereits vor Beginn einer Simulation bekannt.

Sequentielle Simulationen mittels diskreter Ereignisse müssen zwangsläufig alle Ereignisse in einer globalen Ordnungsbeziehung behandeln. Dies kann der Natur des zu simulierenden Systems entgegenstehen bzw. zu einer Überspezifikation des Modells führen, was als nachteilig angesehen werden kann, da es sehr rechenzeitaufwändig ist. Ein weiterer Nachteil besteht darin, dass sie einen zentralen Ereignisspeicher benötigen, welcher alle in der Simulation anfallenden Ereignisse in die notwendige globale Ordnungsbeziehung bringt.

Neben dem damit verbundenen nachteiligen Erfordernis eines hohen Ressourcenaufwandes muss damit ein relativ großer Anteil der gesamten Rechenzeit einer Simulation allein zum Sortieren der Listen des zentralen Ereignisspeichers verwendet werden.

Der Erfindung liegt somit die Aufgabe zugrunde, ein Verfahren zur Ablaufsteuerung von sequentiellen objektorientierten Systemsimulationen anzugeben, das eine bessere Nutzung der Ressourcen eines Computers bei der Durchführung einer Systemsimulation ermöglicht und einen schnelleren Simulationsablauf ermöglicht.

Gemäß der Erfindung wird die Aufgabe dadurch gelöst, dass die Steuerung des Simulationsablaufes in einer ersten Simulationsebene durch ein Hauptprogramm nach einem im Hauptprogramm gespeicherten und aus determinierten Zyklusschritten bestehenden Zyklus erfolgt,
dass zur Abarbeitung eines ersten Zyklusschrittes eines ersten Zyklus mindestens eine in dem ersten Zyklusschritt erste Instanz einer in dem ersten Zyklusschritt ersten Klasse durch das Hauptprogramm zur Erzeugung mindestens eines ersten Ereignisses ausgewählt wird, wobei das Ereignis durch einen mit dem parametrisierten Simulationsprogrammteil berechneten Wert, mindestens bestehend aus einem Informationswert und einem Zeitwert mit einer Zyklusnummer und einer Zyklusschrittnummer, realisiert wird, der in einem zu einer Zielinstanz zugeordneten Ereignisspeicher gespeichert wird und nach Abschluss der Erzeugung des ersten oder aller Ereignisse die Programmsteuerung an das Hauptprogramm zurückgegeben wird,
dass das Hauptprogramm gegebenenfalls eine oder mehrere weitere Instanzen aus der gleichen oder einer anderen Klasse zur Erzeugung und Speicherung mindestens je eines Ereignisses auswählt, wenn diese im ersten Zyklusschritt angemeldet sind, bis alle in dem Zyklusschritt angemeldeten Instanzen abgearbeitet sind und die Abarbeitung des ersten Zyklusschrittes durch die Rückgabe der Programmsteuerung an das Hauptprogramm beendet ist,
dass zur Abarbeitung eines weiteren Zyklusschrittes des ersten Zyklus mindestens eine in dem weiteren Zyklusschritt erste Instanz einer in dem weiteren Zyklusschritt ersten Klasse durch das Hauptprogramm ausgewählt wird, wobei der parametrisierte Simulationsprogrammteil der ausgewählten Instanz den ihr zugeordneten Ereignisspeicher über Suchparameter nach Ereignissen durchsucht,
dass bei Übereinstimmung der Suchparameter der zugehörige Informationswert des Ereignisses durch den zu der Instanz gehörenden parametrisierten Simulationsprogrammteil, entsprechend der Eigenschaften der Instanz, verarbeitet wird, dass im Ergebnis der Verarbeitung kein, ein oder mehrere Ereignisse erzeugt und in einem einer Zielinstanz zugeordneten Ereignisspeicherbereich gespeichert werden und die Programmsteuerung an das Hauptprogramm zurückgegeben wird,
dass bei keiner Übereinstimmung der Suchparameter mit den Parametern der im zugehörigen Ereignisspeicher gespeicherten Ereignisse die Programmsteuerung an das Hauptprogramm zurückgegeben wird,
dass weitere Instanzen nacheinander, zur Suche und Verarbeitung von Ereignissen, ausgewählt werden bis alle dem zweiten Zyklusschritt angemeldeten Instanzen abgearbeitet sind und die Abarbeitung des weiteren Zyklusschrittes, durch die Rückgabe der Programmsteuerung an das Hauptprogramm, beendet ist,
dass das Hauptprogramm alle weiteren Zyklusschritte eines Zyklus, sofern vorhanden, nacheinander durchläuft, bis das Ende des ersten Zyklus erreicht ist und dass das Hauptprogramm die Abarbeitung der Simulation in einem nachfolgenden Zyklus periodisch fortsetzt, bis entweder eine vorgegebene Zyklusanzahl durchlaufen oder kein aktuelles Ereignis mehr zu verarbeiten ist,
dass in ausgewählten Zyklusschritten und/oder Zyklen des Simulationsablaufs Werte von Ereignissen und/oder durch die Verarbeitung von Ereignissen durch eine Instanz erzeugte Werte gespeichert und nachfolgend, durch einen Auswertungsprogrammteil, ausgewertet werden.

Die Steuerung des Simulationsablaufes erfolgt durch ein Hauptprogramm. Da der Ablauf der Kommunikation zwischen Instanzen nach einem vorher bekannten Zyklus, mit einer festgelegten Anzahl von Zyklusschritten, abläuft, ist dieser im Hauptprogramm zur Ablaufsteuerung, in Form eines Programmcodes, hinterlegt.

Ein Zyklus bestimmt einen Durchlauf der Simulation in einer Simulationsebene. Eine Systemsimulation kann sich über eine oder mehrere Simulationsebenen erstrecken, wobei sowohl der Zeitpunkt als auch die Reihenfolge bei einem Simulationsebenenwechsel durch das Hauptprogramm gesteuert wird.

Zur Abarbeitung einer ersten Simulationsebene wählt das Hauptprogramm nacheinander Instanzen aus der gleichen oder verschiedenen Klassen aus, welche dann Ereignisse erzeugen. Das heißt das Hauptprogramm verzweigt die Programmabarbeitung in einen, der Instanz zugeordneten, parametrisierten Simulationsprogrammteil zur Berechnung eines Wertes. Zu diesem Zweck sind im Hauptprogramm, jeweils zu einem Zyklusschritt eines Zyklus zugeordnet, Instanzen angemeldet, welche bei der Abarbeitung der Simulation berücksichtigt werden müssen. Ein Ereignis stellt einen Wert dar, der einen Informationswert und einen Zeitwert umfasst. Der Zeitwert besteht dabei aus einer Zyklusnummer und einer Zyklusschrittnummer und dient beispielsweise der Steuerung der Verarbeitung von Ereignissen in einer zeitlichen Reihenfolge. Der Informationswert kann beispielsweise zu übertragende Daten oder ein Information über den Grund der Erzeugung des Ereignisses beinhalten.

Der zur Speicherung von aktuellen Programmdaten vorgesehene Speicherbereich, der Ereignisspeicher, ist in Bereiche eingeteilt, wobei jeder Instanz ein eigener Bereich dieses Speichers, ein Ereignisspeicherbereich, zugeordnet ist. Wird nun durch eine ausgewählte Instanz ein Ereignis erzeugt, also ein Wert berechnet, erfolgt nachfolgend die Speicherung dieses Wertes in dem Ereignisspeicherbereich der Instanz, für die das Ereignis bestimmt ist. Durch diese erfindungsgemäße Dezentralisierung des Ereignisspeichers entfällt der im Stand der Technik notwendige Teilwert des Ereignisses, welcher für die Adresse der Zielinstanz beinhaltet.

Nach der Erzeugung aller Ereignisse in einem ersten Zyklusschritt eines ersten Zyklus setzt das Hauptprogramm die Abarbeitung in einem weiteren Zyklusschritt des gleichen Zyklus fort, bis alle Zyklusschritte des aktuellen Zyklus durchlaufen wurden. Jede durch das Hauptprogramm ausgewählte Instanz jeder Klasse verarbeitet die ihr zugeordneten Ereignisse und erzeugt dabei kein, ein oder mehrere Ereignisse für sich selbst oder andere Instanzen und speichert diese dann wiederum den einzelnen Instanzen zugeordnet ab. Dabei kann die Reihenfolge der Verarbeitung der Ereignisse im Ereignisspeicherbereich vorgegeben werden. Enthält der Ereignisspeicherbereich der zur Programmfortsetzung ausgewählten Instanz kein Ereignis, gibt die Instanz die Programmsteuerung wieder an das Hauptprogramm zurück, welches dann die Abarbeitung mit der nachfolgend auszuwählenden Instanz fortsetzt.

Derart werden alle in den jeweiligen Zyklusschritten eines Zyklus angemeldeten Instanzen abgearbeitet. Das Ende des Simulationsdurchlaufs kann beispielsweise nach Ablauf einer festgelegten Zyklusanzahl erreicht werden. Die Simulation wird auch beendet wenn kein Ereignis mehr durch eine Instanz zu verarbeiten ist.

Zur nachfolgenden Analyse und Darstellung der Simulationsergebnisse werden während des Simulationsablaufes Werte gespeichert. Diese Werte können Ereignisse, Teilwerte von Ereignissen oder durch die Verarbeitung von Ereignissen, durch eine Instanz, erzeugte Zwischenwerte sein. Die Analyse dieser Werte kann durch das Hauptprogramm, einen dafür vorgesehenen Analyseteil des Hauptprogramms oder ein vom Hauptprogramm unabhängiges Analyseprogramm erfolgen. Im Ergebnis der Analyse können beispielsweise Aussagen über eine Empfangsfeldstärkeverteilung im zu untersuchenden Simulationsgebiet, das Verhalten eines Mobilfunknetzes in Abhängigkeit der Anzahl der Mobilfunkteilnehmer oder ihrer Bewegung innerhalb des Simulationsgebietes oder das Verhalten des Netzes bei Veränderung einzelner Parameter, wie räumlich Aufteilung der Basisstationen oder Änderung der Senderleistung, getroffen werden.

In einer günstigen Ausführung des Verfahrens ist vorgesehen, dass die Simulation nach dem Durchlaufen der ersten Simulationsebene in einer weiteren Simulationsebene fortsetzt und die Simulation nach der Abarbeitung aller Simulationsebenen in der ersten Simulationsebene fortgesetzt wird.

Nach dem erfindungsgemäßen Verfahren kann die Ablaufsteuerung während einer Systemsimulation in einer oder in mehreren Simulationsebenen ablaufen. Dazu kann eine erste Simulationsebene beispielsweise die funkrelevanten Teile eines Mobilfunknetzes abbilden, in dem verschiedene Objekte miteinander kommunizieren. In einer zweiten Simulationsebene kann der Kommunikationsablauf innerhalb eines, in der ersten Ebene abgebildeten, Objektes abgebildet werden. In einer weiteren Ebene ist beispielsweise die Kommunikation innerhalb einer Baugruppe des Objektes darstellbar. Der Ablaufsteuerung sind die Simulationsebenen bekannt. Sie steuert den Programmablauf entsprechend der Vorgaben durch alle vorhandenen Simulationsebenen, indem es nach der Abarbeitung eines Zyklus in einer, im jeweiligen Programmablauf ersten Simulationsebene in eine weitere Simulationsebene, zur Abarbeitung eines Zyklus der weiteren Simulationsebene, verzweigt und die Abarbeitung, nach dem Zyklusende der weiteren Simulationsebene, prioritätsgesteuert in der ersten oder einer nachfolgenden Simulationsebene fortsetzt.

In einer Ausgestaltung des erfindungsgemäßen Verfahrens ist vorgesehen, dass die Simulation während der Abarbeitung eines Zyklusschrittes eines Zyklus einer ersten Simulationsebene in einer weiteren Simulationsebene verzweigt wird und nach Beendigung der Abarbeitung in der weiteren Simulationsebene die Abarbeitung in einer nachfolgenden oder der ersten Simulationsebene fortgesetzt wird.

Eine Programmverzweigung in eine weitere Simulationsebene kann nicht nur nach dem Durchlaufen eines gesamten Zyklus der ersten Simulationsebene erfolgen, sondern auch während der Abarbeitung eines Zyklusschrittes eines Zyklus der ersten Ebene. Auch in diesem Fall sind der Ablaufsteuerung sowohl die Reihenfolge als auch die Simulationsebenanzahl bekannt. Das Durchlaufen der Simulationsebenen kann beispielsweise durch Vorgaben oder durch aktuelle Simulationszustände gesteuert erfolgen.

In einer weiteren Ausgestaltung des erfindungsgemäßen Verfahrens ist vorgesehen, dass in der weiteren Simulationsebene das gleiche Verfahren zur Ablaufsteuerung der Systemsimulation oder ein anderes verwendet wird.

Bei einem Simulationsablauf über mehrerer Simulationsebenen wird das erfindungsgemäße Verfahren in der ersten Simulationsebene genutzt. Innerhalb weiteren Simulationsebenen kann das erfindungsgemäße Verfahren ebenfalls oder ein anderes Verfahren, beispielsweise das im Stand der Technik beschriebene Verfahren der Ablaufsteuerung mittels diskreter Ereignisse, genutzt werden.

In einer weiteren Ausgestaltungsform des erfindungsgemäßen Verfahrens ist vorgesehen, dass nach der Verarbeitung der Ereignisse durch die zugehörige Instanz das Ereignis aus dem Ereignisspeicherbereich gelöscht wird.

Nach der Verarbeitung eines oder aller Ereignisse des Ereignisspeichers, der einer Instanz zugeordnet ist, oder zu einem späteren Zeitpunkt werden die Ereignisse aus dem Ereignisspeicher gelöscht oder durch neuere Ereignisse überschrieben.

In einer besonderen Ausführung der Erfindung ist vorgesehen, dass durch eine Partialisierung des Speichers oder durch Parametrisierung der Instanz eine Einteilung des Ereignisspeichers in Ereignisspeicherbereiche vorgenommen wird und jeder Ereignisspeicherbereich jeweils einer Instanz fest zugeordnet ist.

Jeder Instanz wird ein Teil eines, für die Speicherung von Ereignissen vorgesehenen Speicherbereiches zugeordnet. In diesem, der Instanz zugeordneten und damit dezentralen Ereignisspeicher werden alle empfangenen Ereignisse der jeweiligen Instanz, bis zu deren Verarbeitung durch die Instanz selbst, gespeichert. Eine Unterteilung des Speichers kann beispielsweise durch eine Partialisierung, also die Einteilung des Speichers in Bereiche mit einer Beginn- und einer Ende-Speicheradresse einer Instanz mittels einer Tabelle, vorgenommen werden. Eine weitere Möglichkeit besteht in der Zuordnung der Parameter des zugehörigen Speicherbereiches zu der jeweiligen Instanz selbst. Die Instanz kennt dann entweder die zugeordnete Beginn-Speicheradresse und die Größe oder die Ende-Speicheradresse des der Instanz zugeordneten Ereignisspeicherbereiches. Durch die Dezentralisierung des Ereignisspeichers ist es, im Gegensatz zu dem im Stand der Technik genutzten zentralen Ereignisspeichers, nicht mehr notwendig, die Adresse der Zielinstanz innerhalb eines Ereignisses zu speichern.

In einer besonderen Ausführungsform der Erfindung ist vorgesehen, dass Instanzen Ereignisse nur in im Hauptprogramm festgelegten Ereignisspeicherbereichen speichern.

Gesteuert durch das Hauptprogramm kann eine Instanz Ereignisse nur an bestimmte Instanzen senden, dass heißt sie kann Ereignissee nur in bestimmten jeweils einer Instanz zugeordneten dezentralen Ereignisspeichern ablegen. Damit wird eine logischer Kommunikationsablauf der Instanzen gewährleistet.

In einer günstigen Ausführungsform des Verfahrens ist vorgesehen, dass die Steuerung der sequentiellen Abarbeitung von Ereignissen innerhalb eines Zyklusschrittes in einem einer Instanz zugeordneten Ereignisspeicher durch den Zeitwert des Ereignisses, durch nutzerdefinierte Prioritäten oder durch eine topologische Sortierung der Instanznummer, welche dann ein Bestandteil des Ereignisses ist, erfolgt.

Sind in einem, einer Instanz zugeordneten, Ereignisspeicher mehrerer Ereignisse gespeichert, muss die Reihenfolge der Verarbeitung der Ereignisse, welche innerhalb des parametrisierten Simulationsprogrammteils nacheinander erfolgt, gesteuert werden. Zur Steuerung der Reihenfolge kann beispielsweise der Zeitwert der Ereignisse genutzt werden. Eine Abarbeitung kann dann über diesen Zeitwert in aufsteigender oder fallender Reihenfolge erfolgen. Neben der Steuerung durch den Zeitwert bestehen weitere Möglichkeiten in der Auswertung der Instanznummer, der das jeweilige Ereignis erzeugenden Quellinstanz. Die Instanznummer muss für diesen Fall ein Bestandteil des, durch die Quellinstanz erzeugten Ereignisses sein.

In einer weiteren günstigen Ausführung des Verfahrens ist vorgesehen, dass die Verarbeitung von Ereignissen verschiedener Instanzen innerhalb eines Zyklusschrittes, durch eine Anordnung in verschiedene Threads, parallel erfolgt.

Die Verarbeitung von Ereignissen innerhalb des parametrisierten Simulationsprogrammteils erfolgt nacheinander. Zur Steigerung der Verarbeitungsgeschwindigkeit einer Simulation auf einem Mehrprozessorsystem kann aber die Verarbeitung von Ereignissen verschiedener Instanzen zeitlich parallel zueinander, durch eine Anordnung der Programmteile in verschiedenen Threads (Programmreihen), erfolgen.

In einer weiteren günstigen Ausführungsform des Verfahrens ist vorgesehen, dass Ereignisse, welche von einer Instanz zu einem Zeitwert empfangen und verarbeitet werden, Ereignisse für andere Instanzen oder sich selbst mit demselben Zeitwert erzeugen.

Bei der Erzeugung von Ereignissen durch eine Instanz wird durch den zugehörigen parametrisierten Simulationsprogrammteil ein Wert berechnet der unter anderen einem Zeitwert beinhaltet. Dieser wird beispielsweise bei der Steuerung der Verarbeitungsreihenfolge von Ereignissen verwendet und besteht aus einer Zyklusnummer und einer Zyklusschrittnummer. Eine Instanz kann also durch die Verarbeitung eines Ereignisses aus dem zugehörigen Ereignisspeicherbereiches ein neues Ereignis für andere Instanzen oder sich selbst mit dem Zeitwert des zu verarbeitenden Ereignisses erzeugen.

In einer weiteren günstigen Gestaltungsform des Verfahrens ist vorgesehen, dass Ereignisse, welche von einer Instanz zu einem Zeitwert empfangen und verarbeitet werden, Ereignisse für andere Instanzen oder sich selbst mit einem anderen Zeitwert erzeugen.

Eine Instanz kann durch die Verarbeitung eines Ereignisses aus dem zugehörigen Ereignisspeicherbereich ein neues Ereignis für andere Instanzen oder sich selbst mit einem Zeitwert erzeugen, welcher sich in der Zyklusnummer und/oder dem Zyklusschritt von dem Zeitwert des zu verarbeitenden Ereignisses unterscheidet.

Die Erfindung soll nachfolgend anhand von vier Ausführungsbeispielen näher erläutert werden. In den zugehörigen Zeichnungen zeigt
- Fig. 1: einen durch diskrete Ereignisse gesteuerten Simulationsablauf aus dem Stand der Technik,
- Fig. 2: einen möglichen Ereigniszyklus für das erfindungsgemäße Verfahren,
- Fig. 3: eine Darstellung der verfahrensgemäßen Ebenen,
- Fig. 4: ein Beispiel der Ablaufsteuerung einer Simulation durch das erfindungsgemäße Verfahren,
- Fig. 5: das graphisch dargestellte Ergebnis einer Simulation im Mobilfunksektor in einem Untersuchungsgebiet und
- Fig. 6: eine graphische Darstellung der benötigten Rechenzeiten im Vergleich des erfindungsgemäßen Verfahrens zum Stand der Technik.

### Ausführungsbeispiel 1:

Dem Ausführungsbeispiel ist eine Erläuterung der verwendeten Begriffe und deren Beziehungen zueinander vorangestellt.

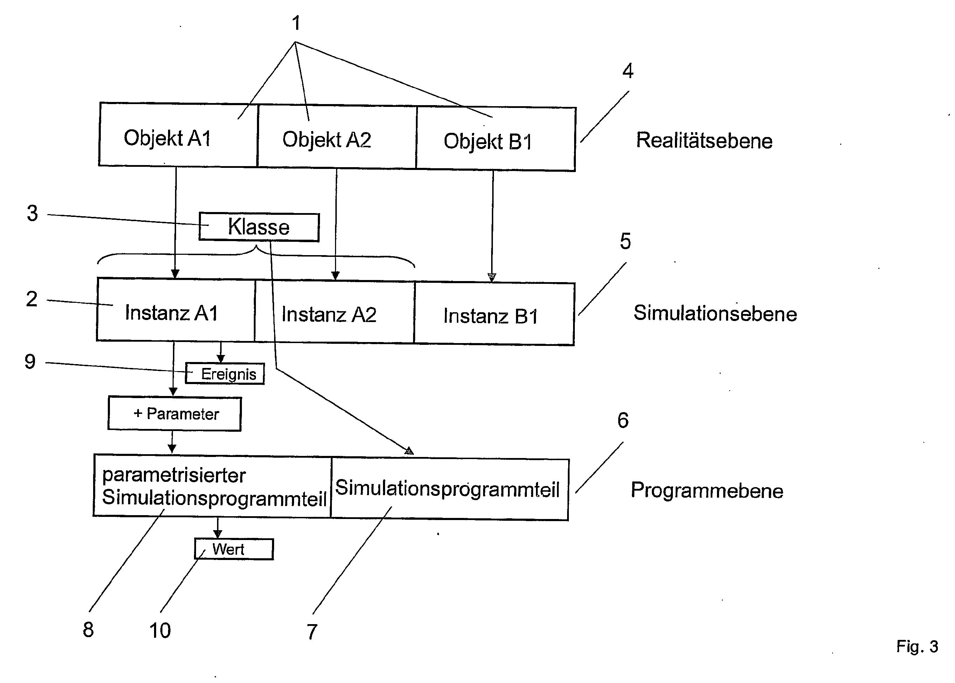

Zur Darstellung von Objekten 1 einer Realitätsebene 4 in einer Simulationsebene 5 werden diese durch sogenannten Instanzen 2, wie in der Fig. 3 dargestellt, abgebildet. Mehrere dieser Instanzen 2, welche mindestens eine gemeinsame Eigenschaft besitzen, werden in eine Klasse 3 der Simulationsebene 5 eingeordnet. Für den speziellen Fall einer Simulation eines Mobilfunknetzes könnten dies die Klassen 3 der Handys, der Basisstationen oder der Übertragungskanäle sein.

Die Realisierung einer Klasse 3 der Simulationsebene 5 erfolgt durch einen Simulationsprogrammteil 7 in der Programmebene 6, welcher die gemeinsamen Eigenschaften oder das gleiche Verhalten der zur Klasse 3 gehörigen Instanzen 2 umsetzt.

Da sich die Instanzen 2 der Simulationsebene 5, genau wie die Objekte 1 der Realitätsebene 4, durch mindestens eine Eigenschaft voneinander unterscheiden, werden den Instanzen 2 Parameter zugeordnet.

Eine Instanz 2 einer Klasse 3 der Simulationsebene 5 wird nach der Zuordnung mindestens eines Parameters in einem parametrisierten Simulationsprogrammteil 8 der Programmebene 6 realisiert. Dabei muss mindestens einer dieser zugeordneten Parameter von Instanz 2 zu Instanz 2 unterschiedlich sein, dass heißt die Instanzen 2 werden individualisiert. Ein Unterschied der Klasse 3 Handys kann beispielsweise im Parameter Telefonnummer liegen.

Während des Simulationsablaufes erzeugen ausgewählte Instanzen 2 Ereignisse 9. Diese Ereignisse 9 werden in der Programmebene 6 durch einen Wert 10, mindestens bestehend aus einem Informationswert und einem Zeitwert mit einer Zyklusnummer und einer Zyklusschrittnummer, realisiert. Mittels dieser erzeugter Ereignisse 9 kommunizieren die Instanzen 2 der Simulationsebene 5 miteinander.

In diesem Beispiel wird eine Simulation, innerhalb eines festgelegten Gebietes, für eine Mobilfunknetz beschrieben. Dazu müssen dem Hauptprogramm, neben den Daten für den Simulationsraum, Daten über die im Simulationsgebiet befindlichen Basisstationen, die Mobilfunkteilnehmer, ihre Standorte und ihre Ortsveränderungen bekannt sein. Weiterhin muss das Hauptprogramm Informationen darüber enthalten, welche Instanz 2 zu welchen Zeitpunkt welche Aktion veranlasst. Damit sind beispielsweise der Verbindungsaufbau oder -abbau für ein Telefonat oder die Übertragung von Gesprächsdatenpaketen gemeint. Die zeitliche Zuordnung der einzelnen Aktionen der Mobilfunkteilnehmer, das heißt in welchem Zyklusschritt 12 welches Zyklus 11 eine das Objekt 1 abbildende Instanz 2 ein Ereignis 9 erzeugt, kann entweder vorher festgelegt oder nach Vorgaben durch einen Zufallsprogrammteil bestimmt werden.

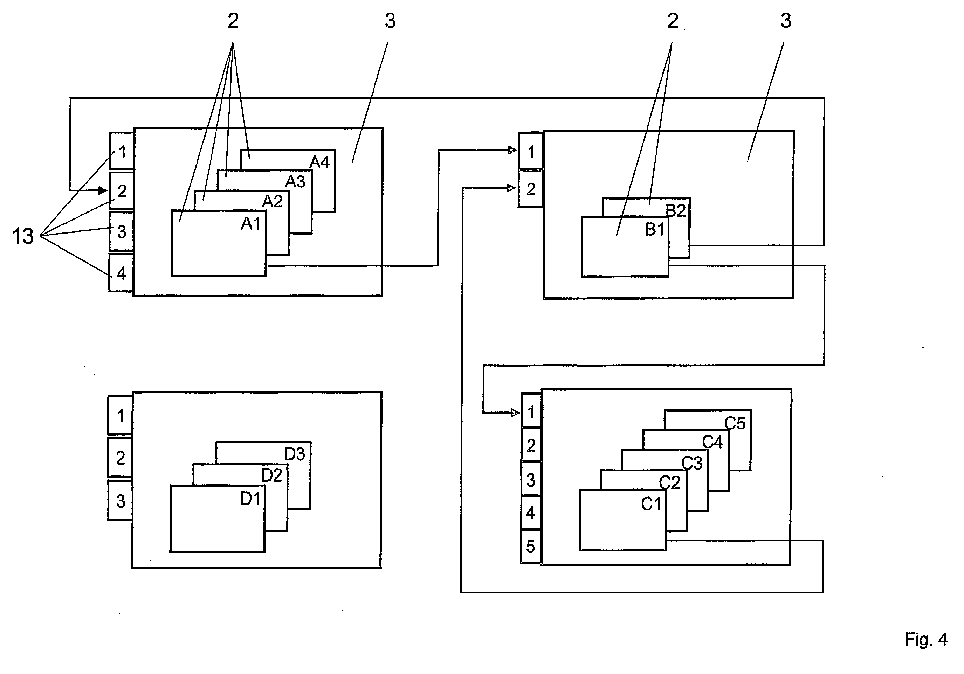

Das Hauptprogramm steuert den Simulationsablauf nach dem ihm bekannten Durchlauf eines Zyklus 11 mit einer festgelegten Zyklusschrittanzahl. Dazu wird, beginnend mit dem ersten Zyklusschritt 12 des ersten Zyklus 11, das Hauptprogramm die Programmverarbeitung in die einzelnen, je eine Instanz 2 realisierenden, parametrisierten Simulationsprogrammteile 8 verzweigen. Nach der Programmabarbeitung innerhalb eines parametrisierten Simulationsprogrammteils 8, bei der beispielsweise ein Ereignis 9 erzeugt wird, wird die Ablaufsteuerung wieder an das Hauptprogramm zurückgegeben und die Abarbeitung in einer weiteren, in diesem Zyklusschritt 12 angemeldeten, Instanz 2 durch Übergabe der Programmsteuerung an den zugehörigen parametrisierten Simulationsprogrammteil 8 fortgesetzt. Die bei der Abarbeitung der parametrisierten Simulationsprogrammteile 8 erzeugten Werte 10 stellen die Ereignisse 9 des Simulationsablaufes dar, welche in den, einzelnen Instanzen 2 fest zugeordneten, Ereignisspeicherbereichen 13 dezentral gespeichert werden. Im Beispiel könnte der Mobilfunkteilnehmer A1, welcher durch die Instanz 2 A1 auf der Simulationsebene 5 abgebildet wird, ein Gespräch mit einem weiteren Mobilfunkteilnehmer A2 aufbauen. Das von A1 erzeugte Ereignis 9 wird für diesen Fall im Ereignisspeicherbereich 13 des Übertragungskanals B1 abgespeichert, siehe Fig. 4.

Nach der Abarbeitung aller im Zyklusschritt 12 angemeldeten Instanzen 2 aller in der Simulation eingetragenen Klassen 3 setzt das Hauptprogramm die Simulation im nachfolgenden Zyklusschritt 12 fort.

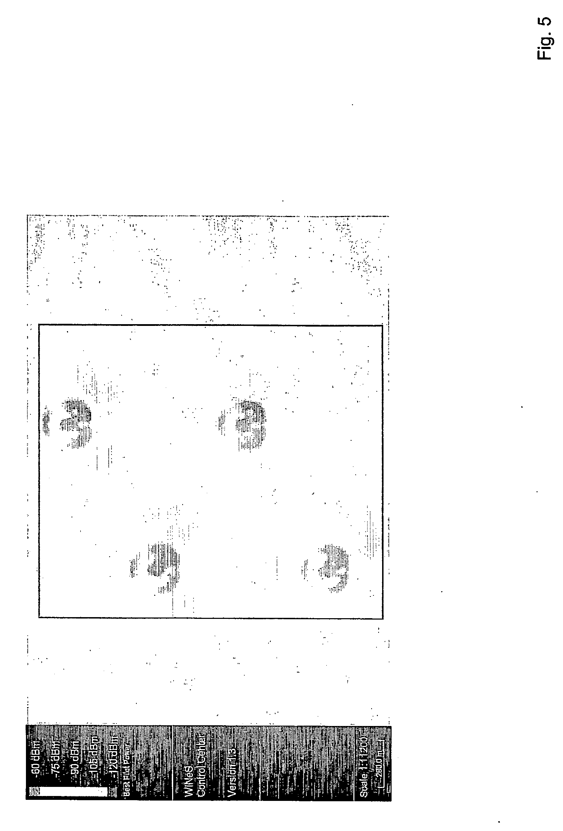

Zu diesem Zweck erfolgt die Übergabe der Programmsteuerung durch das Hauptprogramm zu einem bestimmten Zeitpunkt an den den Übertragungskanal B1 realisierenden parametrisierten Simulationsprogrammteil 8. Dieser verarbeitet den im Ereignisspeicherbereich 13 gespeicherten Wert 10, welcher das von A1 erzeugte Ereignis 9 darstellt, entsprechend seiner Eigenschaften. Das zu übertragende Ereignis 9 von A1 wird durch die Eigenschaften des Übertragungskanals verändert. Im Ergebnis der Verarbeitung von B1 wird ein weiteres Ereignis 9 für die Basisstation C1 erzeugt. Dieses Ereignis 9 wird nun im Ereignisspeicherbereich 13 der Instanz 2 C1, die die Basisstation C1 abbildet, gespeichert. Nach der Abarbeitung weiterer Instanzen 2 und/oder Zyklusschritte 12 wird die Programmsteuerung durch das Hauptprogramm an das, die Instanz 2 C1 realisierende, parametrisierte Simulationsprogrammteil 8 übergeben. Dieses verarbeitet das Ereignis 9 und erzeugt ein weiteres, welches dem Übertragungskanal B2 zugeordnet gespeichert wird. Das die Instanz 2 B2 realisierende parametrisierte Simulationsprogrammteil 8 verarbeitet das Ereignis 9 und erzeugt ein weiteres, welches dem Mobilfunkteilnehmer A2, der durch die Instanz 2 A2 abgebildet wird, zugeordnet gespeichert wird. Dieses Ereignis 9 wird wiederum durch die Instanz 2 A2 verarbeitet und verursacht, da es sich hierbei um den Verbindungsaufbau zwischen A1 und A2 handelt, das "Klingeln" des gesprächsempfangenden Mobiltelefons. Neben diesem Verbindungsaufbau steuert das Hauptprogramm weitere Kommunikationen zwischen verschiedenen anderen Instanzen 2 und speichert zu Analysezwecken ausgewählte Werte 10, Teilwerte oder Zwischenergebnisse einer Verarbeitung ab. Diese werden durch einen Analyseprogrammteil verarbeitet und beispielsweise wie in Fig. 5 graphisch dargestellt. Durch die Auswertung der Grafik kann der Fachmann Aussagen über Schwachstellen innerhalb der Simulationsumgebung treffen. Nachfolgend besteht nun die Möglichkeit einen weiteren Simulationsablauf mit veränderten Parametern eines oder mehrerer Objekte durchzuführen und die Ergebnisse der Simulationen gegenüberzustellen.

### Ausführungsbeispiel 2:

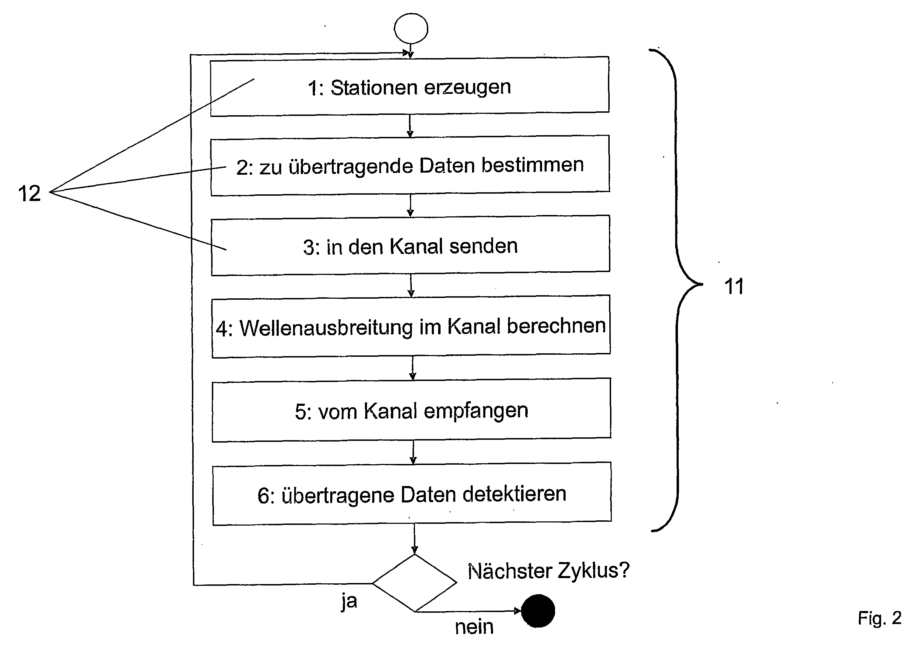

In einem weiteren Beispiel werden in einem GSM-System acht Zeitschlitze der Dauer 0.577 ms in einem Rahmen der Dauer 4.615 ms übertragen. Der in Fig. 2 beispielhaft angegebene Zyklus 11 kann nun, je nach gewünschter zeitlicher Auflösung des zu simulierenden Modells, auf jeden Zeitschlitz oder auch auf jeden Zeitrahmen angewendet werden, um damit eine Simulationsablaufsteuerung für zeitdiskrete und objektorientierte Systemsimulationen des GSM-Mobilfunksystems nach dem erfindungsgemäßen Verfahren zu realisieren. Somit kann eine zeitdiskrete Systemsimulation eines Funkzugangsnetzes nach dem GSM-Mobilfunkstandard mit dem erfindungsgemäßen Verfahren im Ablauf gesteuert werden.

### Ausführungsbeispiel 3

Die folgenden Ausführungen beziehen sich auf das Produkt "WiNeS - Wireless Network System Simulator" der Radioplan GmbH, Dresden.

Ein vorhandener zeitdiskreter und objektorientierter Systemsimulator für das UMTS Mobilfunknetz ist so modular entworfen worden, dass seine Simulationsablaufsteuerung ausgetauscht werden kann. Die Simulationsablaufsteuerung ist also eine Komponente, welche vom das Funkzugangsnetz modellierenden Teil des zeitdiskreten und objektorientierten Systemsimulators für UMTS verwendet wird. Es existieren zwei völlig getrennt verwendbare Simulationsablaufsteuerungen. Die erste Simulationsablaufsteuerung implementiert ein sequentielles Verfahren mittels diskreter Ereignisse nach Fig. 1. Diese Simulationsablaufsteuerung beruht auf dem *public-domain tool* PtolemyII 1.0.1 der *University of California at Berkeley,* USA (http://ptolemy.eecs.berkelev.edu) und ist in der Programmiersprache Java implementiert. Eine zweite Simulationsablaufsteuerung implementiert das erfindungsgemäße Verfahren nach Anspruch 1 und Fig. 4 mit einem Zyklus 11 nach Fig.2, ebenfalls in der Programmiersprache Java.

Um eine Beschleunigung des Simulationsablaufes unter gleichen Simulationsbedingungen nachzuweisen, wurde ein beispielhaftes Untersuchungsgebiet als Ausschnitt eines UMTS-Netzes mit beiden Simulationsablaufsteuerungen für eine konstant gehaltene Simulationszeit (simulierte Echtzeit) simuliert und dabei die benötigten Rechenzeiten für beide Simulationsablaufsteuerungen bei verschiedenen Verkehrslasten verglichen. Dabei war die verwendete Rechnerhardware und -software bis auf die Simulationsablaufsteuerung identisch. Die Verkehrslast ist hierbei definitionsgemäß proportional mit der Anzahl der simulierten Mobilstationen.

Der von den Mobilstationen benutzte Dienst war ein bidirektionaler und leitungsvermittelter Dienst mit einer Nenndatenrate von 12.2 kbit/s und einer Sprachaktivität von 66%. Als Testrechner wurde ein handelsüblicher Personal Computer mit einem Prozessor AthlonXP1.7 und mit dem Betriebssystem Microsoft Windows 2000 Professional verwendet. Die verwendete *Java Virtual Machine* war: java version "1.3.1_02" Java(TM) 2 Runtime Environment, Standard Edition (build 1.3.1_02-b02), Java HotSpot(TM) Client VM (build 1.3.1_02-b02), mixed mode. Das simulierte UMTS-Testgebiet bestand aus 4 NodeBs mit einem Abstand von jeweils 2000m. Jeder NodeB beherbergt drei Zellen, so dass insgesamt also 12 Zellen zur Verfügung standen. Zur geographischen Anordnung des Untersuchungsgebietes siehe auch Fig. 5.

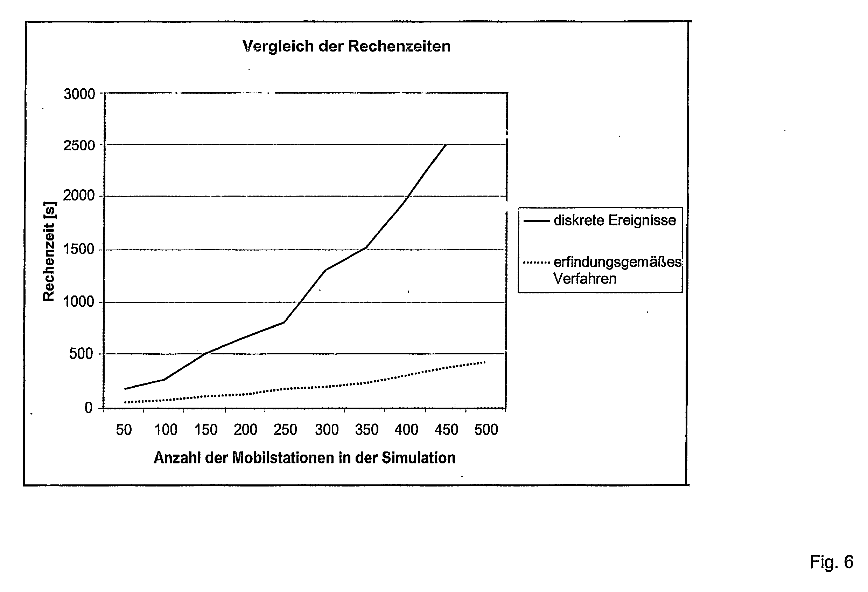

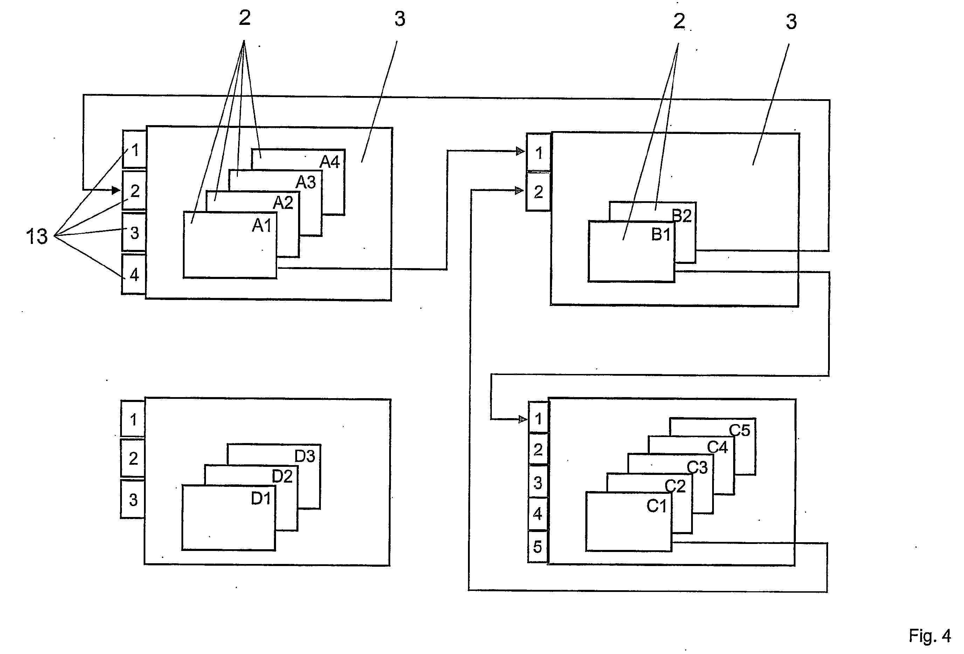

Das Ergebnis des Vergleiches der benötigten Rechenzeiten für identische Simulationen, aber unterschiedliche Simulationsablaufsteuerungen ist in Fig. 6 dargestellt. Für jeweils konstante Simulationszeiten wurde die Anzahl der sich in der Simulation befindlichen Mobilstationen erhöht. In Fig. 6 ist deutlich zu erkennen, dass die Simulationsablaufsteuerung nach dem erfindungsgemäßen Verfahren bei allen Verkehrslasten deutlich kürzere Rechenzeiten für eine gleiche Simulationslast und -zeit benötigt, als die Simulationsablaufsteuerung nach dem bisherigen Standardverfahren mittels diskreter Ereignisse.

Die festgestellte Beschleunigung des Simulationsablaufes ist nach Fig. 6 durch Anwendung des erfindungsgemäßen Verfahrens dabei derart deutlich, dass insgesamt eine wesentlich zeiteffizientere Simulationsablaufsteuerung des erfindungsgemäßen Verfahrens gegenüber dem bisherigen Standardverfahren mittels diskreter Ereignisse erreicht wird, selbst wenn aus Fig. 6 implementierungsspezifische Eigenheiten der Implementierung des Simulationsverfahrens mittels diskreter Ereignisse in PtolemyII, siehe dazu (J.S.Davis II, E.A.Lee, et. al.: Heterogeneous Concurrent Modeling and Design in Java, in technical report UCB/ERL No. M99/40, University of California, Berkeley, USA, July 1999), herausgerechnet werden.

### Ausführungsbeispiel 4:

Die Übertragungen von Informationen über die WCDMA (*wideband code division multiple access*) Luftschnittstelle im Mobilfunkstandard UTRAN/FDD (*universal terrestrial radio access network* / *frequency divison duplex*) erfolgt in Zeitrahmen mit einer Dauer von 10 ms, siehe z.B. (H. Holma and A. Toskala: WCDMA for UMTS, John Wiley & Sons., Chichester, UK, 2000, ISBN 0-471-72051-8). Das erfindungsgemäße Verfahren mit dem in Fig. 2 dargestellten Zyklus 11 wird wiederum zur Steuerung des Ablaufs einer zeitdiskreter Systemsimulationen nach dem UTRAN/FDD-Mobilfunkstandard genutzt.

Bei einer WCDMA-Luftschnittstelle ist allerdings eine schnelle Leistungsregelung unablässig für eine effiziente Arbeitsweise der Luftschnittstelle selbst, siehe z.B. wiederum (H. Holma and A. Toskala: WCDMA for UMTS, John Wiley & Sons., Chichester, UK, 2000, ISBN 0-471-72051-8). Diese schnelle Leistungsregelung arbeitet in UTRAN/FDD 15-mal schneller als der Wechsel der Zeitrahmen. Das heißt, pro Zeitrahmen wird 15-mal die Sendeleistung der Funkstationen angepasst. Das Anpassen der Sendeleistung betrifft aber nur die Zyklusschritte 12 3, 4 und 5 des Zyklus 11 nach Fig. 2. Diese drei Empfangszeitpunkte müssten also 15-mal innerhalb des Zyklus 11 abgearbeitet werden, um eine zeitdiskrete Systemsimulation eines Funkzugangsnetzes nach dem UTRAN/FDD Mobilfunkstandard bei Modellierung von schneller Leistungsregelung im Ablauf zu steuern. Werden die drei genannten Empfangszeitpunkte von Ereignissen 9 als ein eigener Zyklus 11 aufgefasst, welcher insgesamt 15-mal innerhalb des Zyklus 11 nach Fig. 2 abgearbeitet wird, dann kann diese Aufgabe mit dem erfindungsgemäßen Verfahren durch eine Aufteilung der Simulation in mehrere Simulationsebenen gelöst werden. Dazu wird in der ersten Ebene der globale Simulationsablauf dargestellt und in einer zweiten Ebene der die Sendeleistung der Funkstationen anpassende schnellere Simulationsteil in den die Simulation dann zu bestimmten Zeitpunkten immer wieder verzweigt wird.

### Bezugszeichenliste

- 1: Objekt
- 2: Instanz
- 3: Klasse
- 4: Realitätsebene
- 5: Simulationsebene
- 6: Programmebene
- 7: Simulationsprogrammteil
- 8: parametrisierter Simulationsprogrammteil
- 9: Ereignis
- 10: Wert
- 11: Zyklus
- 12: Zyklusschritt
- 13: Ereignisspeicherbereich

## Patentansprüche

1. Verfahren zur Ablaufsteuerung von sequentiellen objektorientierten Systemsimulationen, in dem Objekte mit zumindest einigen gleichen Eigenschaften zu Objektgruppen zusammengefasst werden und die Objektgruppen in Klassen abgebildet werden und jede Klasse durch einen Simulationsprogrammteil realisiert wird, wobei die Abbildung eines Objektes einer Objektgruppe in einer Instanz der Klasse **dadurch** erfolgt, dass die Instanz durch eine Einstellung mindestens eines Parameters in dem Simulationsprogrammteil realisiert wird, wodurch dieser zu einem parametrisierten Simulationsprogrammteil wird, und in dem die Instanzen zur Simulation der Kommunikation zwischen Objekten Ereignisse erzeugen und verarbeiten, was durch einen Ablauf der parametrisierten Simulationsprogrammteile realisiert wird, wobei der Simulationsablauf durch Aktivierungen von Instanzen gesteuert wird, wobei die Steuerung des Simulationsablaufes in einer ersten Simulationsebene (5) durch ein Hauptprogramm nach einem im Hauptprogramm gespeicherten und aus determinierten Zyklusschritten (12) bestehenden Zyklus (11) erfolgt,
**dadurch gekennzeichnet,**
**dass** zur Abarbeitung eines ersten Zyklusschrittes (12) eines ersten Zyklus (11) mindestens eine in dem ersten Zyklusschritt (12) erste Instanz (2) einer in dem ersten Zyklusschritt (12) ersten Klasse (3) durch das Hauptprogramm zur Erzeugung mindestens eines ersten Ereignisses (9) ausgewählt wird, wobei das Ereignis (9) durch einen mit dem parametrisierten Simulationsprogrammteil (8) berechneten Wert (10), mindestens bestehend aus einem Informationswert und einem Zeitwert mit einer Zyklusnummer und einer Zyklusschrittnummer, realisiert wird, der in einem zu einer Zielinstanz zugeordneten Ereignisspeicher (13) gespeichert wird und nach Abschluss der Erzeugung des ersten oder aller Ereignisse (9) die Programmsteuerung an das Hauptprogramm zurückgegeben wird,
**dass** das Hauptprogramm gegebenenfalls eine oder mehrere weitere Instanzen (2) aus der gleichen oder einer anderen Klasse (3) zur Erzeugung und Speicherung mindestens je eines Ereignisses (9) auswählt, wenn diese im ersten Zyklusschritt (12) angemeldet sind, bis alle in dem Zyklusschritt (12) angemeldeten Instanzen (2) abgearbeitet sind und die Abarbeitung des ersten Zyklusschrittes (12) durch die Rückgabe der Programmsteuerung an das Hauptprogramm beendet ist,
**dass** zur Abarbeitung eines weiteren Zyklusschrittes (12) des ersten Zyklus (11) mindestens eine in dem weiteren Zyklusschritt (12) erste Instanz (2) einer in dem weiteren Zyklusschritt (12) ersten Klasse (3) durch das Hauptprogramm ausgewählt wird, wobei der parametrisierte Simulationsprogrammteil (8) der ausgewählten Instanz (2) den ihr zugeordneten Ereignisspeicher (13) über Suchparameter nach Ereignissen (9) durchsucht,
**dass** bei Übereinstimmung der Suchparameter der zugehörige Informationswert des Ereignisses (9) durch den zu der Instanz (2) gehörenden parametrisierten Simulationsprogrammteil (8), entsprechend der Eigenschaften der Instanz (2), verarbeitet wird, dass im Ergebnis der Verarbeitung kein, ein oder mehrere Ereignisse (9) erzeugt und in einem einer Zielinstanz zugeordneten Ereignisspeicherbereich (13) gespeichert werden und die Programmsteuerung an das Hauptprogramm zurückgegeben wird,
**dass** bei keiner Übereinstimmung der Suchparameter mit den Parametern der im zugehörigen Ereignisspeicher (13) gespeicherten Ereignisse (9) die Programmsteuerung an das Hauptprogramm zurückgegeben wird,
**dass** weitere Instanzen (2) nacheinander, zur Suche und Verarbeitung von Ereignissen (9), ausgewählt werden, bis alle in dem zweiten Zyklusschritt (12) angemeldeten Instanzen (2) abgearbeitet sind und die Abarbeitung des weiteren Zyklusschrittes (12), durch die Rückgabe der Programmsteuerung an das Hauptprogramm beendet ist,
**dass** das Hauptprogramm alle weiteren Zyklusschritte (12) eines Zyklus (11), sofern vorhanden, nacheinander durchläuft, bis das Ende des ersten Zyklus (11) erreicht ist und dass das Hauptprogramm die Abarbeitung der Simulation in einem nachfolgenden Zyklus (11) periodisch fortsetzt, bis entweder eine vorgegebene Zyklusanzahl durchlaufen oder kein aktuelles Ereignis (9) mehr zu verarbeiten ist,
**dass** in ausgewählten Zyklusschritten (12) und/oder Zyklen (11) des Simulationsablaufs Daten von Ereignissen (9) und/oder durch die Verarbeitung von Ereignissen (9) durch eine Instanz (2) erzeugte Daten gespeichert und nachfolgend, durch einen Auswertungsprogrammteil, ausgewertet werden.

2. Verfahren nach Anspruch 1, **dadurch gekennzeichnet, dass** die Simulation nach dem Durchlaufen der ersten Simulationsebene (5) in einer weiteren Simulationsebene (5) fortsetzt und die Simulation nach der Abarbeitung aller Simulationsebenen (5) in der ersten Simulationsebene (5) fortgesetzt wird.

3. Verfahren nach Anspruch 1, **dadurch gekennzeichnet, dass** die Simulation während der Abarbeitung eines Zyklusschrittes (12) eines Zyklus (11) einer ersten Simulationsebene (5) in einer weiteren Simulationsebene (5) verzweigt wird und nach Beendigung der Abarbeitung in der weitern Simulationsebene (5) die Abarbeitung in einer nachfolgenden oder der ersten Simulationsebene (5) fortgesetzt wird.

4. Verfahren nach Anspruch 2, **dadurch gekennzeichnet, dass** in der weiteren Simulationsebene (5) das gleiche Verfahren zur Ablaufsteuerung der Systemsimulation oder ein anderes verwendet wird.

5. Verfahren nach Anspruch 1, **dadurch gekennzeichnet, dass** nach der Verarbeitung der Ereignisse (9) durch die zugehörige Instanz (2) das Ereignis (9) aus dem Ereignisspeicherbereich (13) gelöscht wird.

6. Verfahren nach Anspruch 1, **dadurch gekennzeichnet, dass** durch eine Partialisierung des Speichers oder durch Parametrisierung der Instanz (2) eine Einteilung des Ereignisspeichers in Ereignisspeicherbereiche (13) vorgenommen wird und jeder Ereignisspeicherbereich (13) jeweils einer Instanz (2) fest zugeordnet ist.

7. Verfahren nach Anspruch 1, **dadurch gekennzeichnet, dass** Instanzen (2) Ereignisse (9) nur in im Hauptprogramm festgelegten Ereignisspeicherbereichen (13) speichern.

8. Verfahren nach Anspruch 1, **dadurch gekennzeichnet, dass** die Steuerung der sequentiellen Abarbeitung von Ereignissen (9) innerhalb eines Zyklusschrittes (12) in einem einer Instanz (2) zugeordneten Ereignisspeicherbereich durch den Zeitwert des Ereignisses (9), durch nutzerdefinierte Prioritäten oder durch eine topologische Sortierung der Instanznummer, welche dann ein Bestandteil des Ereignisses (9) ist, erfolgt.

9. Verfahren nach Anspruch 1, **dadurch gekennzeichnet, dass** die Verarbeitung von Ereignissen (9) verschiedener Instanzen (2) innerhalb eines Zyklusschrittes (12), durch eine Anordnung in verschiedene Threads, parallel erfolgt.

10. Verfahren nach Anspruch 1, **dadurch gekennzeichnet, dass** Ereignisse (9), welche von einer Instanz (2) zu einem Zeitwert empfangen und verarbeitet werden, Ereignisse (9) für andere Instanzen (2) oder sich selbst mit demselben Zeitwert erzeugen.

11. Verfahren nach Anspruch 1, **dadurch gekennzeichnet, dass** Ereignisse (9), welche von einer Instanz (2) zu einem Zeitwert empfangen und verarbeitet werden, Ereignisse (9) für andere Instanzen (2) oder sich selbst mit einem anderen Zeitwert erzeugen.

## Claims

1. A process for the sequence control of sequential object-oriented system simulations in which objects with at least several identical properties are combined into object groups and the object groups are mapped into classes and each class is realized by a simulation program part, whereby the mapping of an object from an object group in an instance of the class occurs in such manner that the instance is realized by setting at least one parameter in the simulation program part, whereby the latter becomes a parameterized simulation program part, in which the instances for simulation of communication between objects generate and process events, which is realized by a sequence of the parameterized simulation program parts, whereby the simulation sequence is controlled by activations of instances, wherein control of the simulation sequence occurs in a first simulation level (5) by a main program after a cycle (11) saved in the main program and consisting of determined cycle increments (12),
**characterized in**
**that** for processing a first cycle increment (12) of a first cycle (11), at least one instance (2) in the first cycle increment (12) of a first class (3) in the first cycle increment (12) is selected by the main program for generating at least one first event (9), whereby the event (9) is realized by a value (10) calculated with the parameterized simulation program part (8), at least consisting of an information value and a time value with a cycle number and a cycle increment number, which is saved in an event memory (13) assigned to a target instance and after generation of the first or all events (9) is concluded the program control is returned to the main program,
**that** the main program, if necessary, selects one or more further instances (2) from the same or another class (3) for generation and saving of at least one event (9) each, if these are defined in the first cycle increment (12), until all the instances (2) defined in the cycle increment (12) are processed and the processing of the first cycle increment (12) is terminated by the return of the program control to the main program,
**that** for processing a further cycle increment (12) of the first cycle (11) at least a first instance (2) in the further cycle increment (12) of a first class (3) in the further cycle increment (12) is selected by the main program, whereby the parameterized simulation program part (8) of the selected instance (2) searches thorough the event memory (13) assigned to it for events (9) via search parameters,
**that** in the case of correspondence of the search parameters, the associated information value of the event (9) by the parameterized simulation program part (8) belonging to the instance (2), corresponding to the properties of the instance (2), is processed, that as a result of processing no, one or several events (9) are generated and saved in an event memory area (13) assigned to a target instance and the program control is returned to the main program,
**that** in the case of no correspondence of the search parameters with the parameters of the events (9) saved in the associated event memory (13), the program control is returned to the main program,
**that** further instances (2) in succession, for searching and processing events (9), are selected until all the instances (2) defined in the second cycle increment (12) are processed and the processing of the further cycle increment (12), by the return of the program control to the main program, is terminated,
**that** the main program runs through all further cycle increments (12) of a cycle (11) in succession, insofar as they are present, until the end of the first cycle (11) is reached, and that the main program periodically continues processing the simulation in a subsequent cycle (11), until either a specified number of cycles has passed or no further current event (9) is to be processed,
**that** in selected cycle increments (12) and/or cycles (11) of the simulation sequence, data of events (9) and/or data generated by the processing of events (9) by an instance (2) is saved and subsequently evaluated by an evaluation program part.

2. The process according to claim 1, **characterized in that** the simulation is continued after running through of the first simulation level (5) in a further simulation level (5), and the simulation is continued after processing of all simulation levels (5) in the first simulation level (5).

3. The process according to claim 1, **characterized in that** the simulation is branched during processing of a cycle increment (12) of a cycle (11) of a first simulation level (5) in a further simulation level (5) and after termination of the processing in the further simulation level (5) the processing in a subsequent or the first simulation level (5) is continued.

4. The process according to claim 2, **characterized in that** in the further simulation level (5) the same process for sequence control of the system simulation or another process is used.

5. The process according to claim 1, **characterized in that** the event (9) is deleted from the event memory area (13) after processing of the events (9) by the associated instance (2).

6. The process according to claim 1, **characterized in that** a division of the event memory into event memory areas (13) is realized by a partialization of the memory or by parameterization of the instance (2) and every event memory area (13) is permanently assigned to a respective instance (2).

7. The process according to claim 1, **characterized in that** instances (2) only save events (9) in event memory areas (13) specified in the main program.

8. The process according to claim 1, **characterized in that** control of the sequential processing of events (9) within a cycle increment (12) in an event memory area assigned to an instance (2) occurs through the time value of the event (9), through user-defined priorities or through a topological sorting of the instance number which is then a component of the event (9).

9. The process according to claim 1, **characterized in that** the processing of events (9) of different instances (2) within a cycle increment (12) occurs in parallel through an arrangement into different threads.

10. The process according to claim 1, **characterized in that** events (9) which are received and processed by an instance (2) for a time value generate events (9) for other instances (2) or themselves with the same time value.

11. The process according to claim 1, **characterized in that** events (9) which are received and processed by an instance (2) for a time value generate events (9) for other instances (2) or themselves with another time value.

## Revendications

1. Procédé de commande du déroulement de simulations systématiques, séquentielles, orientées objet, selon lequel on regroupe des objets ayant au moins certaines propriétés identiques pour former des groupes-objet, et on copie les groupes-objet en des classes et on réalise chaque classe par une partie de programme de simulation,
la copie d'un objet d'un groupe-objet se faisant dans une première instance de la classe en ce qu'on réalise l'instance par un réglage d'au moins un paramètre dans la partie de programme de simulation, de façon à devenir une partie de programme de simulation, paramétrée, et en ce que les instances de simulation de la communication entre les objets, génèrent et traitent des évènements ce qui est réalisé par un déroulement des parties de programme de simulation paramétrées,
le déroulement de la simulation étant commandé par l'activation d'instances,
la commande du déroulement de simulations se faisant dans un premier plan de simulation (5) par un programme principal selon un cycle (11) mémorisé dans le programme principal et composé d'étapes de cycles (12), déterminées,
**caractérisé en ce que**
pour traiter une première étape (12) d'un premier cycle (11), on sélectionne au moins une première instance (2) dans la première étape de cycle (12) d'une première classe (3) de la première étape de cycle (12) par le programme principal pour générer au moins un premier évènement (9),
- l'évènement (9) étant réalisé par une valeur (10) calculée avec une partie de programme de simulation (8), paramétrée, se composant au moins d'une valeur d'informations et d'une valeur de temps avec un numéro de cycle et un numéro d'étape de cycle, cette valeur étant enregistrée dans une mémoire d'évènement (13) associée à une instance cible, et à la fin de la génération du premier évènement ou de tous les évènements (9), on retourne la commande de programme au programme principal,
- le programme principal sélectionne le cas échéant une ou plusieurs autres instances (2) à partir de la même classe (3) ou d'une autre classe pour générer et enregistrer chaque fois au moins un évènement (9) si ceux-ci sont indiqués dans la première étape de cycle (12), jusqu'à ce que toutes les instances (2) signalées dans l'étape de cycle (12) soient traitées, et on termine le traitement de la première étape de cycle (12) en retournant la commande de programme au programme principal,
- pour traiter une autre étape de cycle (12) du premier cycle (11), on sélectionne au moins une première instance (2) dans l'autre étape de cycle (12) appartenant à une première classe (3) de l'autre étape de cycle (12) par le programme principal,
- la partie de programme de simulation (8), paramétrée de l'instance sélectionnée (12) passant en revue sa mémoire d'évènements (13) par des paramètres de recherche selon les évènements (9),
- en cas de concordance, on traite le paramètre de recherche de la valeur d'information correspondante de l'évènement (9) par la partie de programme de simulation (8) paramétrée appartenant à l'instance (2) en fonction des propriétés de l'instance (2) **en ce qu'**en résultat du traitement, on ne génère pas d'évènement (9), un évènement ou plusieurs évènements (9), et on les enregistre dans une zone de mémoire d'évènement (13) associée à une instance cible, et on retourne la commande de programme au programme principal,
- en cas de non-concordance des paramètres de recherche avec les paramètres des évènements (9) enregistrés dans la mémoire d'évènements (13) correspondante, on rend la commande de programme au programme principal,
- on sélectionne successivement d'autres instances (2) pour rechercher et traiter des évènements (9) jusqu'à ce que toutes les instances (2) signalées dans la seconde étape de cycle (12) soient traitées, et on termine le traitement de l'autre étape de cycle (12) en rendant la commande de programme au programme principal,
- le programme principal exécute toutes les autres étapes (12) d'un cycle (11) dans la mesure où ces étapes existent, successivement, jusqu'à arriver à la fin du premier cycle (11), et le programme principal poursuit périodiquement le traitement de la simulation dans un cycle suivant (11), jusqu'à ce qu'un nombre prédéfini de cycles soit parcouru ou qu'il n'y a plus d'évènement actuel (9) à traiter,
- dans des étapes de cycles choisies (12) et/ou des cycles (11) du déroulement de simulations, on mémorise les données des évènements (9) et/ou le traitement des évènements (9) par une instance (2) et ensuite, on les exploite par une partie de programme d'exploitation.

2. Procédé selon la revendication 1,
**caractérisé en ce qu'**
après le parcours du premier plan de simulation (5), on poursuit la simulation dans un autre plan de simulation (5), et après le traitement de tous les plans de simulation (5), on poursuit la simulation dans le premier plan de simulation (5).

3. Procédé selon la revendication 1,
**caractérisé en ce que**
pendant le traitement d'une étape (12) d'un cycle (11), on dérive la simulation dans un autre plan de simulation (5), et à la fin du traitement dans cet autre plan de simulation (5), on poursuit le traitement dans un plan de simulation (5) suivant ou dans le premier plan de simulation.

4. Procédé selon la revendication 2,
**caractérisé en ce que**
dans l'autre plan de simulation (5), on utilise le même procédé de commande de déroulement de la simulation systématique ou un autre procédé.

5. Procédé selon la revendication 1,
**caractérisé en ce qu'**
après le traitement des évènements (9) par l'instance correspondante (2), on efface l'évènement (9) de la zone de mémoire d'évènements (13).

6. Procédé selon la revendication 1,
**caractérisé en ce que**
on divise la mémoire d'évènements en zones de mémoires d'évènements (13) par une partition de la mémoire ou par un paramétrage de l'instance (2), et on associe solidairement chaque fois une instance (2) à chaque zone d'évènements (13).

7. Procédé selon la revendication 1,
**caractérisé en ce que**
dans les instances (2), on mémorise les évènements (9) seulement dans des zones de mémoires d'évènements (13) fixées dans le programme principal.

8. Procédé selon la revendication 1,
**caractérisé en ce que**
la commande du traitement séquentiel des événements (9) dans une étape de cycle (12) dans une zone de mémoire d'évènement associée à la première instance (9), se fait par la valeur de temps de l'évènement (9), par des priorités d'utilisateur ou par un classement topologique des numéros d'instances qui fait alors partie de l'évènement (9).

9. Procédé selon la revendication 1,
**caractérisé en ce que**
le traitement des évènements (9) des différentes instances (2) d'une étape de cycle (12), se fait en parallèle par la mise en place de différents liens.

10. Procédé selon la revendication 1,
**caractérisé en ce que**
les évènements (9) qui ont été reçus et traités par une instance (2) correspondant à une valeur de temps, génèrent des évènements (9) pour une autre instance (2) ou pour elle-même avec la même valeur de temps.

11. Procédé selon la revendication 1,
**caractérisé en ce que**
les évènements (9) reçus et traités par une instance (2) pour une valeur de temps, génèrent des évènements (9) pour d'autres instances (2) ou pour elle-même avec une autre valeur de temps.
